(19)

Europäisches
Patentamt
European
Patent Office
Office européen
des brevets

(11) **EP 3 988 996 A1**

(12) **EUROPEAN PATENT APPLICATION**

(43) Date of publication:
   **27.04.2022 Bulletin 2022/17**

(21) Application number: **20202720.7**

(22) Date of filing: **20.10.2020**

(51) International Patent Classification (IPC):
   **G02F 1/35** (2006.01)   **G02F 1/01** (2006.01)
   **G03F 7/20** (2006.01)

(52) Cooperative Patent Classification (CPC):
   **G02F 1/3528; G02F 1/0121; G02F 1/3507;
   G03F 7/70616; G03F 9/7065**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**
   Designated Validation States:
   **KH MA MD TN**

(71) Applicant: **ASML Netherlands B.V.
   5500 AH Veldhoven (NL)**

(72) Inventors:
   • **TRAVERS, John Colin
     Edinburgh EH14 4AS, Scotland (GB)**
   • **BELLI, Federico
     Edinburgh EH14 4AS, Scotland (GB)**
   • **BRAHMS, Malte Christian
     Edinburgh EH14 4AS, Scotland (GB)**
   • **BROUNS, Andreas Johannes Antonius
     5500 AH Veldhoven (NL)**
   • **HUGERS, Ronald Franciscus Herman
     5500 AH Veldhoven (NL)**

(74) Representative: **ASML Netherlands B.V.
   Corporate Intellectual Property
   P.O. Box 324
   5500 AH Veldhoven (NL)**

(54) **HOLLOW-CORE PHOTONIC CRYSTAL FIBER BASED BROADBAND RADIATION GENERATOR**

(57) A broadband radiation source device, comprising a fiber assembly comprising a plurality of optical fibers, each optical fiber being filled with a gas medium; wherein the broadband radiation source device is operable such that subsets of the optical fibers are independently selectable for receiving a beam of input radiation so as to generate a broadband output from only a subset of said plurality of optical fibers at any one time.

**Fig. 14**

Processed by Luminess, 75001 PARIS (FR)

## Description

FIELD

The present invention relates to a hollow-core photonic crystal fiber based broadband radiation generator, and in particular such a broadband radiation generator in relation to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. It would be desirable to improve on present devices for broadband radiation generation.

SUMMARY

In a first aspect of the invention there is provided a broadband radiation source device, comprising a fiber assembly comprising a plurality of optical fibers, each optical fiber being filled with a gas medium; wherein the broadband radiation source device is operable such that subsets of the optical fibers are independently selectable for receiving a beam of input radiation so as to generate a broadband output from only a subset of said plurality of optical fibers at any one time. E.g. proper subsets of the optical fibers are independently selectable so as to generate a broadband output from only a subset of the plurality of optical fibers.

In a second aspect of the invention there is provided a method for generating broadband radiation, comprising: emitting input radiation from a pump source; receiving the input radiation by a selected subset of a plurality of optical fibers; and generating from the selected subset of the plurality of optical fibers a broadband output.

Other aspects of the invention comprise metrology device comprising the broadband light source device of the first aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figure 5 depicts a schematic overview of a level sensor apparatus which may comprise a radiation source according to embodiments of the invention;

- Figure 6 depicts a schematic overview of an alignment sensor apparatus which may comprise a radiation source according to embodiments of the invention;
- Figure 7 is a schematic cross sectional view of a hollow core optical fiber that may form part of a radiation source according to an embodiment in a transverse plane (i.e. perpendicular to an axis of the optical fiber);
- Figure 8 depicts a schematic representation of a radiation source according to an embodiment for providing broadband output radiation;
- Figures 9 (a) and (b) schematically depict the transverse cross-sections of examples of hollow core photonic crystal fiber (HC-PCF) designs for supercontinuum generation;
- Figures 10(a) schematically illustrates a rectangular fiber assembly which comprises a two-dimensional (2D) array of optical fibers (e.g., single-ring HC-PCFs) in accordance with an embodiment;
- Figures 10(b) schematically illustrates a circular fiber assembly which comprises a two-dimensional (2D) array of optical fibers (e.g., single-ring HC-PCFs) in accordance with an embodiment;
- Figures 11(a) illustrates a 1D fiber assembly using individual single-core optical fibers in accordance with an embodiment;
- Figure 11(b) illustrates a 2D fiber assembly using individual single-core optical fibers in accordance with an embodiment;
- Figure 12 schematically illustrates a broadband radiation source comprising a fiber assembly in accordance with an embodiment and a first single beam configuration;
- Figure 13 schematically illustrates a broadband radiation source comprising a fiber assembly in accordance with an embodiment and a multi-beam configuration;
- Figure 14 schematically illustrates a broadband radiation source RDS3 comprising a fiber assembly in accordance with an embodiment and a second single beam configuration;
- Figure 15 schematically illustrates a multiple fiber stacking arrangement according to an embodiment; and
- Figure 16 depicts a block diagram of a computer system for controlling a broadband radiation source.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

<Reticle>

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

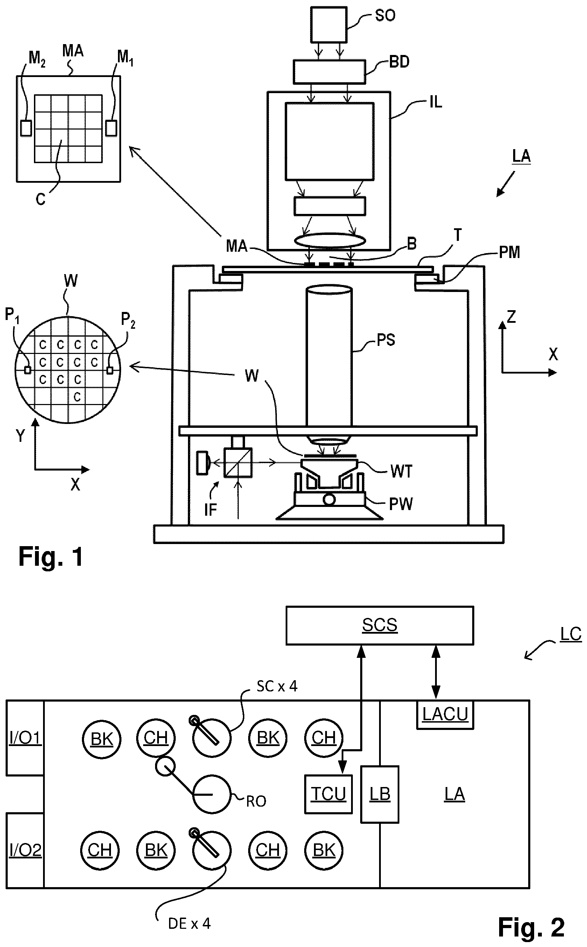

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

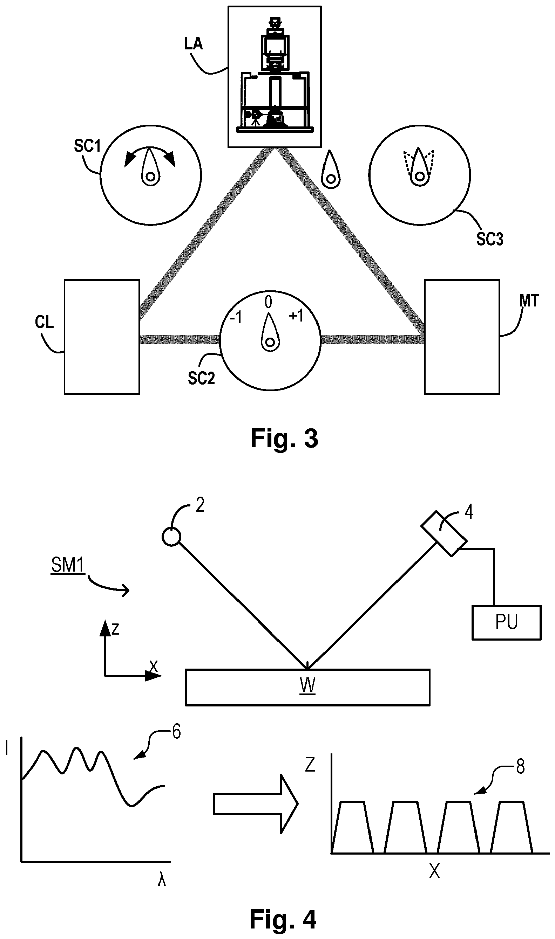

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation.

From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1 incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

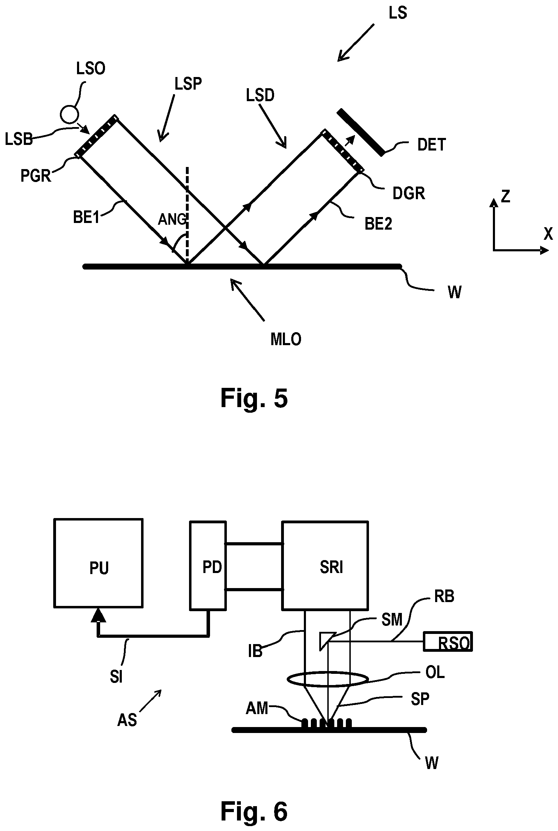

An example of a level or height sensor LS as known in the art is schematically shown in Figure 5, which illustrates only the principles of operation. In this example, the level sensor comprises an optical system, which includes a projection unit LSP and a detection unit LSD.

The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and demultiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

High quality broadband radiation, for example supercontinuum radiation, may be difficult to generate. One method for generating broadband radiation may be to broaden high-power narrow band or single frequency input radiation or pump radiation, for example making use of non-linear, higher order effects. The input radiation (which may be produced using a laser) may be referred to as pump radiation. Alternatively, the input radiation may be referred to as seed radiation. To obtain high power radiation for broadening effects, radiation may be confined into a small area so that strongly localised high intensity radiation is achieved. In those areas, the radiation may interact with broadening structures and/or materials forming a non-linear medium so as to create broadband output radiation. In the high intensity radiation areas, different materials and/or structures may be used to enable and/or improve radiation broadening by providing a suitable non-linear medium.

In some implementations, the broadband output radiation is created in a photonic crystal fiber (PCF). In several embodiments, such a photonic crystal fiber has microstructures around its fiber core assisting in confining radiation that travels through the fiber in the fiber core. The fiber core can be made of a solid material that has non-linear properties and that is capable of generating broadband radiation when high intensity pump radiation is transmitted through the fiber core. Although it is feasible to generate broadband radiation in solid core photonic crystal fibers, there may be a few disadvantages of using a solid material. For example, if UV radiation is generated in the solid core, this radiation might not be present in the output spectrum of the fiber because the radiation is absorbed by most solid material.

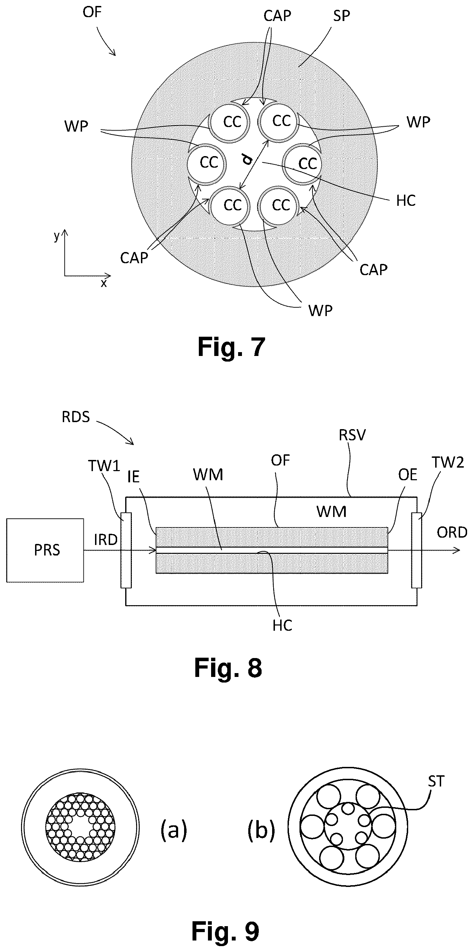

In some implementations, as discussed further below with reference to Figure 8, methods and apparatus for broadening input radiation may use a fiber for confining input radiation, and for broadening the input radiation to output broadband radiation. The fiber may be a hollow core fiber, and may comprise internal structures to achieve effective guiding and confinement of radiation in the fiber. The fiber may be a hollow core photonic crystal fiber (HC-PCF), which is particularly suitable for strong radiation confinement, predominantly inside the hollow core of the fiber, achieving high radiation intensities. The hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light.

Some embodiments relate to a new design of such a broadband radiation source comprising an optical fiber. The optical fiber is a hollow-core, photonic crystal fiber (HC-PCF). In particular, the optical fiber may be a hollow-core, photonic crystal fiber of a type comprising anti-resonant structures for confinement of radiation. Such fibers comprising anti-resonant structures are known in the art as anti-resonant fibers, tubular fibers, single-ring fibers, negative curvature fibers or inhibited coupling fibers. Various different designs of such fibers are known in the art. Alternatively, the optical fiber may be photonic bandgap fibers (HC-PBFs, for example a Kagome fiber).

A number of types of HC-PCFs can be engineered, each based on a different physical guidance mechanism. Two such HC-PCFs include: hollow-core photonic bandgap fibers (HC-PBFs) and hollow-core anti-resonant reflecting fibers (HC-ARFs). Detail on the design and manufacture of HC-PCFs can be found in US patent US2004/015085A1 (for HC-PBFs) and International PCT patent application WO2017/032454A1 (for Hollow Core anti-resonant reflecting fibers), which are incorporated herein by reference. Figure 9(a) shows a Kagome fiber, comprising a Kagome lattice structure.

An example of an optical fiber for use in the radiation source is now described with reference to Figure 7, which is a schematic cross sectional view of the optical fiber OF in a transverse plane. Further embodiments similar to the practical example of the fiber of Figure 7 are disclosed in WO2017/032454A1.

The optical fiber OF comprises an elongate body, which is longer in one dimension compared to the other two dimensions of the fiber OF. This longer dimension may be referred to as an axial direction and may define an axis of the optical fiber OF. The two other dimensions define a plane which may be referred to as a transverse plane. Figure 7 shows a cross-section of the optical fiber OF in this transverse plane (i.e. perpendicular to the axis), which is labelled as the x-y plane. The transverse cross-section of the optical fiber OF may be substantially constant along the fiber axis.

It will be appreciated that the optical fiber OF has some degree of flexibility and therefore the direction of the axis will not, in general, be uniform along the length of the optical fiber OF. The terms such as the optical axis, the transverse cross-section and the like will be understood to mean the local optical axis, the local transverse cross-section and so on. Furthermore, where components are described as being cylindrical or tubular these terms will be understood to encompass such shapes that may have been distorted as the optical fiber OF is flexed.

The optical fiber OF may have any length and it will be appreciated that the length of the optical fiber OF may be dependent on the application. The optical fiber OF may have a length between 1 cm and 10 m, for example, the optical fiber OF may have a length between 10 cm and 100 cm.

The optical fiber OF comprises: a hollow core HC; a cladding portion surrounding the hollow core HC; and a support portion SP surrounding and supporting the cladding portion. The optical fiber OF may be considered to comprise a body (comprising the cladding portion and the support portion SP) having a hollow core HC. The cladding portion comprises a plurality of anti-resonance elements for guiding radiation through the hollow core HC. In particular, the plurality of anti-resonance elements are arranged to confine radiation that propagates through the optical fiber OF predominantly inside the hollow core HC and to guide the radiation along the optical fiber OF. The hollow core HC of the optical fiber OF may be disposed substantially in a central region of the optical fiber OF, so that the axis of the optical fiber OF may also define an axis of the hollow core HC of the optical fiber OF.

The cladding portion comprises a plurality of anti-resonance elements for guiding radiation propagating through the optical fiber OF. In particular, in this embodiment, the cladding portion comprises a single ring of six tubular capillaries CAP. Each of the tubular capillaries CAP acts as an anti-resonance element.

The capillaries CAP may also be referred to as tubes. The capillaries CAP may be circular in cross section, or may have another shape. Each capillary CAP comprises a generally cylindrical wall portion WP that at least partially defines the hollow core HC of the optical fiber OF and separates the hollow core HC from a capillary cavity CC. It will be appreciated that the wall portion WP may act as an anti-reflecting Fabry-Perot resonator for radiation that propagates through the hollow core HC (and which may be incident on the wall portion WP at a grazing incidence angle). The thickness of the wall portion WP may be suitable so as to ensure that reflection back into the hollow core HC is generally enhanced whereas transmission into the capillary cavity CC is generally suppressed. In some embodiments, the capillary wall portion WP may have a thickness between 0.01 - 10.0 $\mu$m.

It will be appreciated that, as used herein, the term cladding portion is intended to mean a portion of the optical fiber OF for guiding radiation propagating through the optical fiber OF (i.e. the capillaries CAP which confine said radiation within the hollow core HC). The radiation may be confined in the form of transverse modes, propagating along the fiber axis.

The support portion is generally tubular and supports the six capillaries CAP of the cladding portion. The six capillaries CAP are distributed evenly around an inner surface if the inner support portion SP. The six capillaries CAP may be described as being disposed in a generally hexagonal formation.

The capillaries CAP are arranged so that each capillary is not in contact with any of the other capillaries CAP. Each of the capillaries CAP is in contact with the inner support portion SP and spaced apart from adjacent capillaries CAP in the ring structure. Such an arrangement may be beneficial since it may increase a transmission bandwidth of the optical fiber OF (relative, for example, to an arrangement wherein the capillaries are in contact with each other). Alternatively, in some embodiments, each of the capillaries CAP may be in contact with adjacent capillaries CAP in the ring structure.

The six capillaries CAP of the cladding portion are disposed in a ring structure around the hollow core HC. An inner surface of the ring structure of capillaries CAP at least partially defines the hollow core HC of the optical fiber OF. The diameter d of the hollow core HC (which may be defined as the smallest dimension between opposed capillaries, indicated by arrow d) may be between 10 and 1000 $\mu$m. The diameter d of the hollow core HC may affect the mode field diameter, impact loss, dispersion, modal plurality, and non-linearity properties of the hollow core HC optical fiber OF.

In this embodiment, the cladding portion comprises a single ring arrangement of capillaries CAP (which act as anti-resonance elements). Therefore, a line in any radial direction from a center of the hollow core HC to an exterior of the optical fiber OF passes through no more than one capillary CAP.

It will be appreciated that other embodiments may be provided with different arrangements of anti-resonance elements. These may include arrangements having multiple rings of anti-resonance elements and arrangements having nested anti-resonance elements. Figure 9(a) shows an embodiment of HC-PCFs with three rings of capillaries CAP stacking on top of each other along the radial direction. In this embodiment, each capillary CAP is in contact with other capillaries both in the same ring and in a different ring. Furthermore, although the embodiment shown in Figure 7 comprises a ring of six capillaries, in other embodiments, one or more rings comprising any number of anti-resonance elements (for example 4, 5, 6, 7, 8, 9, 10, 11 or 12 capillaries) may be provided in the cladding portion.

Figure 9(b) shows a modified embodiment of the above discussed HC-PCFs with a single ring of tubular capillaries. In the example of Figure 9(b) there are two coaxial rings of tubular capillaries 21. For holding the inner and outer rings of tubular capillaries 21, a support tube ST may be included in the HC-PCF. The support tube may be made of silica.

The tubular capillaries of the examples of Figure 7 and Figures 9 (a) and (b) may have a circular cross-sectional shape. Other shapes are also possible for the tubular capillaries, like elliptical or polygonal cross-sections. Additionally, the solid material of the tubular capillaries of the examples of Figure 7 and Figures 9 (a) and (b) may comprise plastic material, like PMA, glass, like silica, or soft glass.

Figure 8 depicts a radiation source RDS for providing broadband output radiation. The radiation source RDS comprises a pulsed pump radiation source PRS or any other type of source that is capable of generating short pulses of a desired length and energy level; an optical fiber OF (for example of the type shown in Figure 7) with a hollow core HC; and a working medium WM (for example a gas) disposed within the hollow core HC. Although in Figure 8 the radiation source RDS comprises the optical fiber OF shown in Figure 7, in alternative embodiments other types of hollow core HC optical fiber OF may be used.

The pulsed pump radiation source PRS is configured to provide input radiation IRD. The hollow core HC of the optical fiber OF is arranged to receive the input radiation IRD from the pulsed pump radiation source PRS, and broaden it to provide output radiation ORD. The working medium WM enables the broadening of the frequency range of the received input radiation IRD so as to provide broadband output radiation ORD.

The radiation source RDS further comprises a reservoir RSV. The optical fiber OF is disposed inside the reservoir RSV. The reservoir RSV may also be referred to as a housing, container or gas cell. The reservoir RSV is configured to contain the working medium WM. The reservoir RSV may comprise one or more features, known in the art, for controlling, regulating, and/or monitoring the composition of the working medium WM (which may be a gas) inside the reservoir RSV. The reservoir RSV may comprise a first transparent window TW1. In use, the optical fiber OF is disposed inside the reservoir RSV such that the first transparent window TW1 is located proximate to an input end IE of the optical fiber OF. The first transparent window TW1 may form part of a wall of the reservoir RSV. The first transparent window TW1 may be transparent for at least the received input radiation frequencies, so that received input radiation IRD (or at least a large portion thereof) may be coupled into the optical fiber OF located inside reservoir RSV. It will be appreciated that optics (not shown) may be provided for coupling the input radiation IRD into the optical fiber OF.

The reservoir RSV comprises a second transparent window TW2, forming part of a wall of the reservoir RSV. In use, when the optical fiber OF is disposed inside the reservoir RSV, the second transparent window TW2 is located proximate to an output end OE of the optical fiber OF. The second transparent window TW2 may be transparent for at least the frequencies of the broadband output radiation ORD of the apparatus 120.

Alternatively, in another embodiment, the two opposed ends of the optical fiber OF may be placed inside different reservoirs. The optical fiber OF may comprise a first end section configured to receive input radiation IRD, and a second end section for outputting broadband output radiation ORD. The first end section may be placed inside a first reservoir, comprising a working medium WM. The second end section may be placed inside a second reservoir, wherein the second reservoir may also comprise a working medium WM. The functioning of the reservoirs may be as described in relation to Figure 8 above. The first reservoir may comprise a first transparent window, configured to be transparent for input radiation IRD. The second reservoir may comprise a second transparent window configured to be transparent for broadband output broadband radiation ORD. The first and second reservoirs may also comprise a sealable opening to permit the optical fiber OF to be placed partially inside and partially outside the reservoir, so that a gas can be sealed inside the reservoir. The optical fiber OF may further comprise a middle section not contained inside a reservoir. Such an arrangement using two separate gas reservoirs may be particularly convenient for embodiments wherein the optical fiber OF is relatively long (for example when the length is more than 1 m). It will be appreciated that for such arrangements which use two separate gas reservoirs, the two reservoirs (which may comprise one or more features, known in the art, for controlling, regulating, and/or monitoring the composition of a gas inside the two reservoirs) may be considered to provide an apparatus for providing the working medium WM within the hollow core HC of the optical fiber OF.

In this context a window may be transparent for a frequency if at least 50%, 75%, 85%, 90%, 95%, or 99% of incident radiation of that frequency on the window is transmitted through the window.

Both the first TW1 and the second TW2 transparent windows may form an airtight seal within the walls of the reservoir RSV so that the working medium WM (which may be a gas) may be contained within the reservoir RSV. It will be appreciated that the gas WM may be contained within the reservoir RSV at a pressure different to the ambient pressure of the reservoir RSV.

The working medium WM may comprise a noble gas such as Argon, Krypton, and Xenon, a Raman active gas such as Hydrogen, Deuterium and Nitrogen, or a gas mixture such as an Argon/Hydrogen mixture, a Xenon/Deuterium mixture, a Krypton/Nitrogen mixture, or a Nitrogen/Hydrogen mixture. Depending on the type of filling gas, the nonlinear optical processes can include modulational instability (MI), soliton self-compression, soliton fission, Kerr effect, Raman effect and dispersive wave generation, details of which are described in WO2018/127266A1 and US9160137B1 (both of which are hereby incorporated by reference). Since the dispersion of the filling gas can be tuned by varying the working medium WM pressure in the reservoir RSR (i.e. gas cell pressure), the generated broadband pulse dynamics and the associated spectral broadening characteristics can be adjusted so as to optimize the frequency conversion

In one implementation, the working medium WM may be disposed within the hollow core HC at least during receipt of input radiation IRD for producing broadband output radiation ORD. It will be appreciated that, while the optical fiber OF is not receiving input radiation IRD for producing broadband output radiation, the gas WM may be wholly or partially absent from the hollow core HC.

In order to achieve frequency broadening high intensity radiation may be desirable. An advantage of having a hollow core HC optical fiber OF is that it may achieve high intensity radiation through strong spatial confinement of radiation propagating through the optical fiber OF, achieving high localised radiation intensities. The radiation intensity inside the optical fiber OF may be high, for example due to high received input radiation intensity and/or due to strong spatial confinement of the radiation inside the optical fiber OF. An advantage of hollow core optical fibers is that they can guide radiation having a broader wavelength range that solid-core fibers and, in particular, hollow core optical fibers can guide radiation in both the ultraviolet and infrared ranges.

An advantage of using a hollow core HC optical fiber OF may be that the majority of the radiation guided inside the optical fiber OF is confined to the hollow core HC. Therefore, the majority of the interaction of the radiation inside the optical fiber OF is with the working medium WM, which is provided inside the hollow core HC of the optical fiber OF. As a result, the broadening effects of the working medium WM on the radiation may be increased.

The received input radiation IRD may be electromagnetic radiation. The input radiation IRD may be received as pulsed radiation. For example, the input radiation IRD may comprise ultrafast pulses, for example, generated by a laser.

The input radiation IRD may be coherent radiation. The input radiation IRD may be collimated radiation, an advantage of which may be to facilitate and improve the efficiency of coupling the input radiation IRD into the optical fiber OF. The input radiation IRD may comprise a single frequency, or a narrow range of frequencies. The input radiation IRD may be generated by a laser. Similarly, the output radiation ORD may be collimated and/or may be coherent.

The broadband range of the output radiation ORD may be a continuous range, comprising a continuous range of radiation frequencies. The output radiation ORD may comprise supercontinuum radiation. Continuous radiation may be beneficial for use in a number of applications, for example in metrology applications. For example, the continuous range of frequencies may be used to interrogate a large number of properties. The continuous range of frequencies may for example be used to determine and/or eliminate a frequency dependency of a measured property. Supercontinuum output radiation ORD may comprise for example electromagnetic radiation over a wavelength range of 100 nm - 4000 nm. The broadband output radiation ORD frequency range may be for example 400 nm - 900 nm, 500 nm - 900 nm, or 200 nm - 2000 nm. The supercontinuum output radiation ORD may comprise white light.

The input radiation IRD provided by the pulsed pump radiation source PRS may be pulsed. The input radiation IRD may comprise electromagnetic radiation of one or more frequencies between 200 nm and 2 $\mu$m. The input radiation IRD may for example comprise electromagnetic radiation with a wavelength of 1.03 $\mu$m. The repetition rate of the pulsed radiation IRD may be of an order of magnitude of 1 kHz to 100 MHz. The pulse energies may have an order of magnitude of 0.1 $\mu$J to 100 $\mu$J, for example 1 - 10 $\mu$J. A pulse duration for the input radiation IRD may be between 10 fs and 10 ps, for example 300 fs. The average power of input radiation IRD may be between 100 mW to several 100 W. The average power of input radiation IRD may for example be 20 - 50 W.

The pulsed pump radiation source PRS may be a laser. The spatio-temporal transmission characteristics of such a laser pulse, e.g. its spectral amplitude and phase, transmitted along the optical fiber OF can be varied and tuned through adjustment of (pump) laser parameters, working component WM variations, and optical fiber OF parameters. Said spatio-temporal transmission characteristics may include one or more of: output power, output mode profile, output temporal profile, width of the output temporal profile (or output pulse width), output spectral profile, and bandwidth of the output spectral profile (or output spectral bandwidth). Said pulse pump radiation source PRS parameters may include one or more of: pump wavelength, pump pulse energy, pump pulse width, pump pulse repetition rate. Said optical fiber OF parameters may include one or more of: optical fiber length, size and shape of the hollow core HC, size and shape of the capillaries, thickness of the walls of the capillaries surrounding the hollow core HC. Said working component WM, e.g. filling gas, parameters may include one or more of: gas type, gas pressure and gas temperature.

The broadband output radiation ORD provided by the radiation source RDS may have an average output power of at least 1 W. The average output power may be at least 5 W. The average output power may be at least 10 W. The broadband output radiation ORD may be pulsed broadband output radiation ORD. The broadband output radiation ORD may have a power spectral density in the entire wavelength band of the output radiation of at least 0.01 mW/nm. The power spectral density in the entire wavelength band of the broadband output radiation may be at least 3 mW/nm.

HC-PCF based broadband radiation sources RDS often suffer from fast performance degradation and short lifetime issues. At present, several failure mechanisms have been identified. A first failure mechanism is fiber contamination typically induced by hydrocarbon deposition on one or both fiber ends. Hydrocarbons may be brought into the reservoir RSV when the radiation source is assembled. Hydrocarbons may also be produced by thermal outgassing of the components inside the reservoir RSV, including the optical fiber OF itself.

A second failure mechanism is fiber overheating. White light generation is accompanied by ionization and heat generation through atomic collisions in gas species and recombination dynamics in plasma. Such heat generated during operation will increase the temperature of the inner cladding surfaces of an optical fiber OF. However, for existing HC-PCFs e.g., such as illustrated in Figures 7, 9(a) or 9(b), fiber geometries do not allow access and efficient cooling of the surfaces of inner cladding waveguide structures. Without effective thermal dissipation, the generated heat will accumulate within the fiber, especially in the case of the fiber being pumped/driven with high repetition rate pulses, until the fiber is overheated and eventually damaged. Overheating of the surfaces of an inner cladding waveguide structure (e.g., tubular capillaries CAP such as illustrated in Figures 7, 9(a) or 9(b)) will also trigger unwanted chemical reactions which can produce outgassing and thus cause further contamination.

A third failure mechanism is Hydrogen induced fiber surface reduction and glassy growth. It has been found that after operating a HC-PCF based broadband radiation source RDS with a Hydrogen containing gas mixture for over a few hundred hours, silicon oxides or $SiO_x$ nanostructures and fluffy glass are grown predominantly at the output tip of the fiber. One of the main root causes of the silicon dioxide growth is reduction of the inner fiber surfaces in the presence of hydrogen plasma. Reduction and etching of silicon dioxide in the presence of hydrogen plasma is a known phenomenon. Hydrogen ions and radicals, such as atomic hydrogen, attack the inner fiber surfaces and cause the reduction of the contacting surfaces by converting silica to silicon, or cause etching of the surfaces by creating volatile silicon monoxide. The growth of silicon dioxide at the end tip of a fiber results in gradual blockage and loss of output power, which will eventually lead to fiber damage and short lifetime of the broadband radiation source RDS.

At present, various measures have been taken individually or in combination to reduce the degradation of HC-PCFs and thus extend the lifetime of HC-PCF based radiation sources. For example, better cleaning methods are used to clean all the components of a HC-PCF based radiation source RDS, in particular those contained in the reservoir RSV. Moreover, components that are made of materials with low outgassing properties are preferred over equivalents that are made of materials with high outgassing properties. In addition, gas mixtures with a higher thermal conductivity are used to help improve thermal dissipation within HC-PCFs. Although the above measures are effective to a certain extent, fiber damage is still difficult to prevent.

Due to the aforementioned fiber lifetime issues, a HC-PCF based radiation source RDS may fail to function after only a short period of operation time. In the case where a HC-PCF based light source is used in a metrology tool, e.g., a scatterometer, topography measurement system, or position measurement system mentioned above, unexpected and/or early failures of a HC-PCF means the whole light source will need to be removed from the tool in order to be repaired or replaced. Replacement of a damaged/degraded fiber requires re-optimization of coupling of the pump laser beam into a new HC-PCF, which is a time-consuming process. After a repaired or replacement radiation source RDS is fitted into the same metrology tool, a complete optical alignment of the radiation beam emitted from the radiation source and other necessary calibrations and characterizations need to be carried out again. The whole process not only adds cost but also causes a significant system downtime.

As described above, in a HC-ARF, the cladding portion comprising a plurality of anti-resonance elements such as tubular capillaries CAP is used for guiding radiation through the hollow core HC. A low loss transmission window of a given HC-ARF is formed between fiber resonances. Within the low loss transmission window, cladding modes that are supported by the anti-resonance elements, e.g., tubular capillaries CAP, are not phase matched to the core mode i.e., the core mode and cladding modes are anti-resonant, which ensures that the core mode is propagating predominantly within the hollow core HC. Whereas, within each fiber resonance band, the core mode is phased matched to the cladding modes, i.e. the core mode and cladding modes are resonant, which results in strong coupling of the core mode into the anti-resonance elements. Consequently, the corresponding portion of the light is no longer guided in the hollow core HC. The strong coupling of the core mode into the surrounding glass structure can exacerbate the above-described overheating issue and thus shorten the fiber lifetime. Hence to reduce the interaction between the core mode and the cladding structure, it is desirable to optimize the output spectrum such that its overlap with the fiber resonances is minimized.

For typical HC-ARFs, such as those shown in Figures 7, 9(a) or 9(b), the spectral positions of the fiber resonances are determined by the core-wall thickness (e.g., thickness of the tubular capillaries) and geometry of the surrounding cladding structure (e.g., arrangement of the tubular capillaries). The fiber resonances cannot be eliminated and must be managed in order to optimize for a given spectral bandwidth. The geometry and core-wall thickness, as well as the HC-PCF material, cannot be changed once the fiber has been fabricated. To change the positions of the fiber resonances requires changing one or more of the foregoing fiber parameters, and therefore the use of a different fiber. The lack of flexibility in controlling of post-fabrication fiber resonances imposes stringent requirements on the fiber fabrication process, which inevitably results in higher manufacturing costs.

Existing HC-PCF based broadband radiation sources RDS are typically based on a single-fiber configuration, e.g., the example shown in Figure 8. In order to meet a growing need of large bandwidths, HC-PCFs with multi-octave spanning spectral bandwidths, e.g., from deep ultraviolet (UV) to near-infrared (NIR), are desirable. However, such large bandwidth HC-PCFs are very difficult to fabricate and require precise control of the fiber fabrication process which limits production yield and increases manufacturing costs.

Embodiments described below relate to methods and apparatuses which are capable of mitigating the aforementioned short lifetime issues and/or simultaneously allowing desired flexibility to tune or optimize spectral characteristics of the output radiation (e.g., bandwidth and/or location of the output spectrum) that is otherwise unachievable by existing single-fiber based radiation sources RDS. The core concept of the method is to use more than one optical fiber OF, e.g., HC-PCFs, arranged in a desired manner such that when a current optical fiber OF can be automatically and/or quickly replaced with a new optical fiber having either substantially the same fiber parameters as the current optical fiber OF or other different fiber parameters in order to obtain different output characteristics, e.g., different fiber resonances and/or spectral bandwidths. This method allows multiple optical fibers OF to be switched in an automated and non-invasively manner and therefore obviates the need of following the existing time-consuming fiber replacement process, e.g., removing the current optical fiber OF from the reservoir RSV, placing a new optical fiber OF into the reservoir, and coupling the input radiation into the new optical fiber OF.

In all embodiments, the number of fibers in a fiber assembly may comprise for example, between: 2 and 100 optical fibers, 2 and 50 optical fibers, 2 and 30 optical fibers, 5 and 100 optical fibers, 5 and 50 optical fibers, 5 and 30 optical fibers, 10 and 100 optical fibers, or 10 and 50 optical fibers. The arrangement may be a 1-dimensional (1D) array, a 2D array, an irregular 1D or 2D arrangement, a circular arrangement or any other arrangement. The optical fibers may be all substantially similar, or at least one or more subsets may comprise different properties.

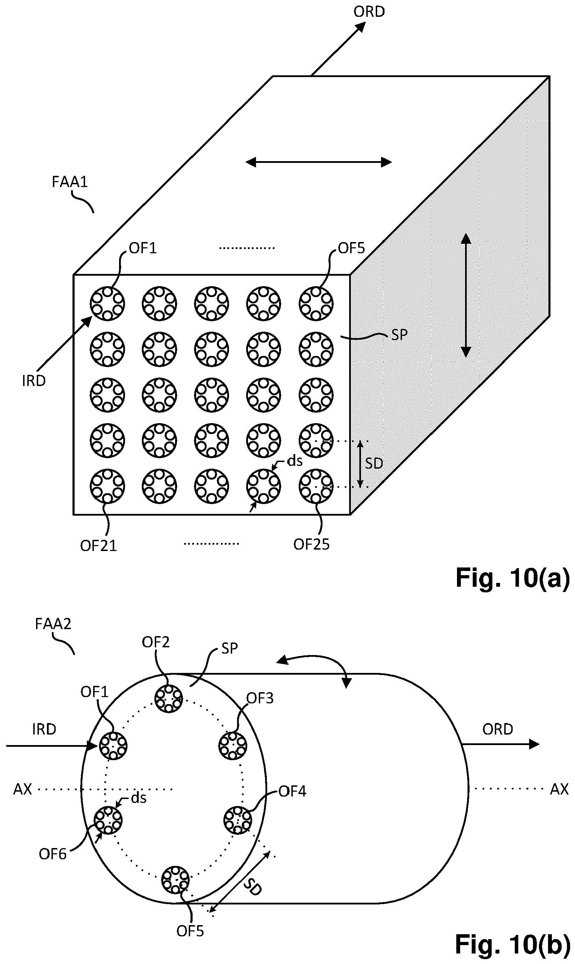

Figures 10(a) schematically illustrates a rectangular fiber assembly FAA1 which comprises a two-dimensional (2D) array of optical fibers (e.g., single-ring HC-PCFs) in accordance with an embodiment. In the specific embodiment shown, the fiber assembly FAA1 may be a multi-cored microstructured fiber comprising a total number of 25 separate cores of HC-PCFs OF1-OF25. The 25 separate hollow cores HC may be formed within a single support portion SP. Note that, the fiber assembly FAA1 may comprise any number and/or any type of optical fibers OF which may be determined based on application needs and/or practicalities of implementation.

The spatial distance DS between the centers of two neighboring hollow cores HC may be at least greater than inner diameter ds of the support portion SP of each HC-PCF that supports in direct contact with the (six) tubular capillaries. As such, any two HC-PCFs may be spatially separated. In some embodiments, the spatial distance DS between any two HC-PCFs may be sufficiently large such that an adjacent optical fiber OF may be less or not affected by e.g., outgassing and/or glassy (silica) growth generated from a neighboring optical fiber OF. The spatial distance DS may be for example up to 2, up to 3, up to 4, or up to 5 times the inner diameter ds of the support portion of each HC-PCF.

Figures 10(b) schematically illustrates a circular fiber assembly FAA2 which comprises a two-dimensional (2D) arrangement of optical fibers OF (e.g., single-ring HC-PCFs) in accordance with an embodiment. In this specific example, the fiber assembly FAA2 comprises a total number of six HC-PCFs OF1-OF6 arranged in a single ring geometry. It should be appreciated that in different embodiments, the circular fiber assembly FAA2 may comprise multiple concentric rings of optical fibers OF. On each fiber ring, there may be any number of optical fibers OF which may be determined based on application needs and/or practicalities of implementation. All the optical fibers OF comprised in each fiber ring may have the same radial distance to the axis AX of the fiber assembly FAA2. Similar to the embodiment shown in Figure 10(a), the spatial distance DS between the centers of two neighboring hollow cores HC may be at least greater than inner diameter ds of the support portion of each HC-PCF which supports or is in direct contact with the (six) tubular capillaries. The spatial distance DS may be for example up to 2, up to 3, up to 4, or up to 5 times the inner diameter ds of the support portion of each HC-PCF.

Both of the fiber assemblies FAA1, FAA2 shown in Figures 10(a) and 10(b) may be manufactured using standard multi-core fiber fabrication techniques, such as, for example, the so-called stack and draw technique. This three (or more) step process comprises: stacking multiple glass tubes into a glass preform, drawing the preform down into a cane with smaller transverse dimensions and further drawing the cane into a fiber. A fiber assembly composed of multiple hollow-core fibers can be directly fabricated based on a variation of this method, more specifically by including the additional step of stacking the canes together before fiber drawing.

Instead of using fiber assemblies which are based on a directly fabricated multi-core microstructured fiber, other types of fiber assemblies may be based on assembling a plurality of individual single-core fibers. Such fiber assemblies may have advantages in allowing for more flexibility in choosing optical fibers and obviating some fabrication difficulties for directly manufacturing a single multi-core microstructured fiber.

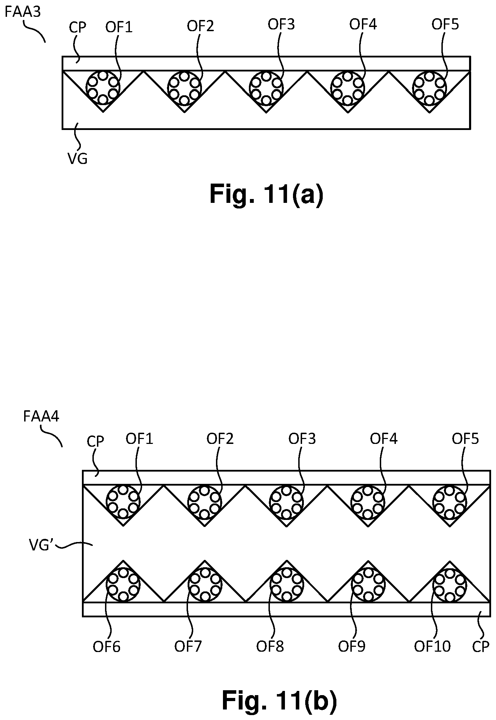

Figures 11(a) and 11(b) respectively illustrate a 1D and a 2D fiber assemblies FAA3, FAA4 using individual single-core optical fibers in accordance with an embodiment. The fiber assemblies FAA3, FAA4 may be obtained by assembling together a plurality of individual single-core optical fibers OF, e.g., HC-PCFs, and arranging them into a fiber array. The size of the fiber array and thus the total number of the optical fibers OF may be flexibly chosen depending on applications.

With reference to Figure 11(a), the fiber assembly FAA3 may comprise a 1D fiber array with (in this specific example) five optical fibers OF1-OF5. The five optical fibers OF1-OF5 may be five HC-PCFs and optionally may be derived from a single HC-PCF and hence possess substantially the same fiber properties. Alternatively, the five HC-PCFs may come from two or more different HC-PCFs and thus at least two of the HC-PCFs may possess different fiber properties. The five HC-PCFs may be held by a V-groove mount VG having a 1D array of v-grooves and a fiber clamp CP. Each V-groove may hold a single fiber. When the clamp CP is fixed on top of the V-groove mount VG, it may be in physical contact with the five HC-PCFs and may exert a suitable clamping force to them. The strength of the clamping force may be adjustable by varying the depth of the V-grooves. The clamping force may fix each HC-PCF in position by pushing them against the wall of respective V-grooves. In some embodiments, fiber sleeves may be used in locations where the clamp CP is in contact with the fibers in order to reduce or minimize the clamping force induced stress to the fibers.

With reference to Figure 11(b), the fiber assembly FAA4 may comprise a 2D fiber array with (in this specific example) ten optical fibers OF1-OF10. The ten optical fibers OF1-OF10 may be ten HC-PCFs which may be derived from a single HC-PCF and hence possess substantially the same fiber properties. Alternatively, the ten HC-PCFs may come from two or more different HC-PCFs and thus some fibers may possess substantially the same fiber properties whilst others may possess different fiber properties, or all may be different. For example, the five HC-PCFs OF1-OF5 in the top row may have one fiber structure whilst the five HC-PCFs OF6-OF10 in the bottom row may have a different fiber structure. Depending on applications, other different fiber combinations may be used in the fiber assembly FAA4. The ten HC-PCFs may be held by a V-groove mount VG' having a corresponding 2D array of v-grooves and two fiber clamps CP. Each V-groove may hold a single fiber. The two fiber clamps may be attached respectively to the top and bottom surfaces of the V-groove mount VG' so as to fix all the optical fibers OF1-0F10 in position.

Note that, the above described 1D or 2D V-groove mount is only an example fiber holder; other different types of fiber holders may be equally applicable. In some embodiments, a single glass substrate comprising a 1D or 2D array of cylindrical holes may be used as the fiber array holder. Each of the cylindrical holes may hold a single optical fiber OF, e.g., HC-PCF. After all the fibers are placed respectively into the cylindrical holes, they may be fixed to their respective cylindrical holes by means of e.g., laser joining or adhesive.

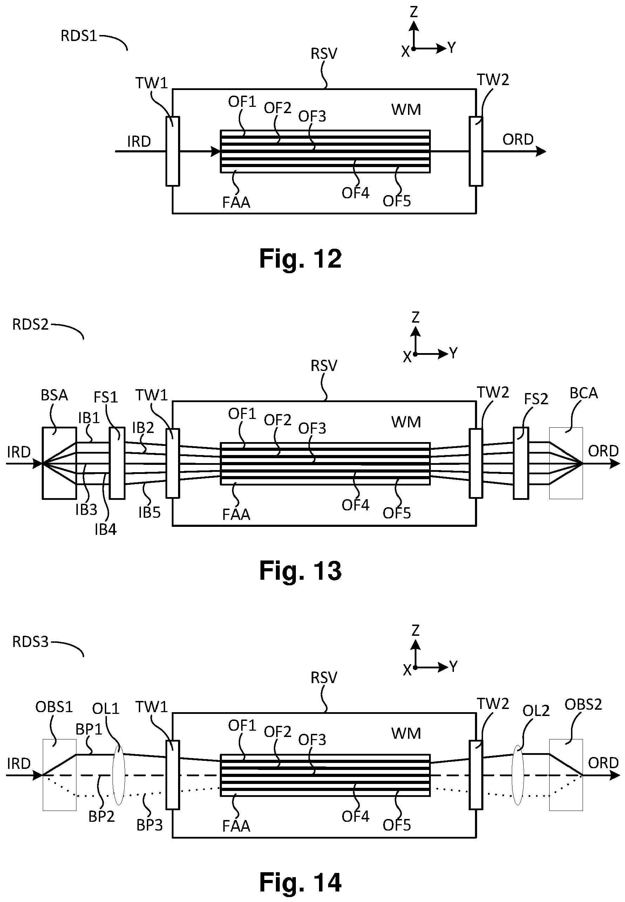

Figure 12 schematically illustrates a broadband radiation source RDS1 arrangement comprising a fiber assembly FAA in accordance with an embodiment and a first single input beam configuration. The fiber assembly FAA may be for example any one of the above described fiber assemblies FAA1-FAA4. In operation, one of the HC-PCFs (e.g., OF3) may be aligned with the optical axis of the radiation source RDS. Within the reservoir RSV, the optical axis of the radiation source RDS may be the beam path of the input radiation IRD. In some embodiments, only one of the HC-PCFs of the fiber assembly FAA may be used to generate broadband radiation at any given time. When a current HC-PCF has reached its lifetime (e.g., performance has degraded to a certain threshold level, damage has occurred) or a different output characteristic is desired, a neighboring or a selected new HC-PCF (e.g., OF4) may be (e.g., automatically) placed into the beam path of the input radiation IRD by (vertically) translating the fiber assembly FAA with respect to the (e.g., fixed) beam path of the input radiation IRD. In case of the fiber assembly FAA2 being used in the radiation source RDS1, a neighboring or a selected new HC-PCF (e.g., OF4) may be (e.g., automatically) placed into the beam path of the input radiation IRD by rotating the fiber assembly FAA2 about its axis AX. Alternatively or additionally, fiber core switching may also be achievable by shifting the beam path of the input radiation IRD with respect to the (e.g., fixed) fiber assembly FAA. In some embodiments, both the beam path of the input radiation IRD and the position or orientation of the fiber assembly FAA may be adjusted together in order to achieve fiber core switching.

With reference to Figure 12, in the case where fiber core switching is achieved solely via translation of the fiber assembly FAA, the fiber assembly FAA may be mounted on a stage module (not shown) comprising one or more actuators (e.g., electromagnetic actuators). The stage module may provide the fiber assembly FAA with multiple (e.g., six) degrees of freedom movement. In this particular embodiment where a linear 1D fiber array is used, the stage module may comprise three linear motion actuators that provide precision movement in the X, Y and Z directions, and two rotary actuators that provide precision angular tilting in the sagittal (tilting about the X direction Rx) and tangential plane (tilting about the Z direction Rz). The X, Y and Z directions are defined with respect to the co-ordinate system shown in Figure 12. The linear actuators may provide a spatial resolution of e.g., less than or equivalent to one micrometer and the rotary actuators may have an angular resolution of e.g., less than or equivalent to one microradian. The travel and angular tilting range may be sufficiently large to cover all the fibers in the fiber assembly FAA. In some embodiments, in addition to high precision linear actuators, the stage module may further comprise coarse movement actuators which are responsible for low precision but long distance movement. When the fiber assembly FAA needs to be replaced (e.g., when all the fibers are damaged or degraded), the coarse movement actuators may be used to ensure the relative position difference between the new fiber assembly FAA and the beam of input radiation IRD is within the travel range of high precision linear actuators.

Whenever a current optical fiber OF is due for replacement, the input radiation IRD may be at least partially blocked by means of e.g., a beam block. The stage module may translate the fiber assembly FAA so as to substantially align the hollow core HC of a new optical fiber OF with the beam path of the input radiation IRD. The distance of the movement may be predetermined based on the spatial separation between any two neighboring fiber cores. Once the new optical fiber OF is moved to the target position, the attenuated or full input radiation IRD may be allowed to enter the hollow core HC of the new fiber and broadband output radiation ORD may be generated. Subsequently, the radiation source RDS1 may enter an input coupling optimization mode in which the coupling between the input radiation IRD and the hollow core HC of the new fiber is optimized. The input coupling optimization may be evaluated by monitoring certain optical characteristics of the output radiation, e.g., spectrum and/or power of the output radiation ORD while adjusting the position of the fiber assembly FAA.

The optimization routine may involve for example fine scanning of the position of the fiber assembly FAA in the X, Y and Z direction sequentially. For example, the stage module may be commanded to scan the position of the fiber assembly FAA first in the X-Z plane to optimize the transverse overlapping between the input radiation IRD and the hollow core HC. Subsequently, the stage module may be commanded to scan the position of the fiber assembly FAA in the Y direction to optimize the focus position of the input radiation IRD into the hollow core HC. In some embodiments, the stage module may be commanded to tilt the fiber assembly FAA in Rx and/or Rz directions in order to further optimize the fiber coupling of the input radiation IRD. As soon as the input coupling optimization is complete, the radiation source RDS1 may enter a normal operating mode in which the position of the fiber assembly FAA is fixed. Note that, it may be that the input coupling optimization is carried out only once when a new fiber assembly FAA is installed. After the initial input coupling optimization, subsequent fiber core switching may be done repeatably without a need for further optimization. However, the input coupling optimization may be repeated any time where required (e.g., for fault-finding purposes). For example, when the optical characteristics (e.g., spectrum and/or power) of the output radiation ORD generated from a new fiber are significantly different from either predefined values or those generated by a previous identical fiber before its degradation/damage, the input coupling optimization may be used to verify whether the performance loss is due to fiber coupling of the input radiation IRD.

In some embodiments, all of the optical fibers OF comprised within the fiber assembly FAA may have substantially the same fiber properties and therefore lead to substantially the same output optical characteristics.

The fiber core switching may be initiated when a current optical fiber is either already damaged or at the verge of damage (e.g., judged by existing performance degradation). Since the HC-PCFs are typically regarded as the lifetime limiting component of a HC-PCF based broadband radiation source RS, the fiber assembly FAA comprising a redundant collection of multiple copies (e.g., 5 copies) of a particular fiber structure can significantly extend (e.g., 5 times) the overall lifetime of the radiation source RS.

In different embodiments, some or all of the optical fibers OF may have different fiber properties/structures which lead to different output optical characteristics. In the case of a 2D fiber assembly, for example assembly FAA1 of Figure 10(a), being used in the radiation source RDS1 of Figure 12, the optical fibers OF in each column may have the substantially the same fiber properties whilst the optical fibers OF in each row may have different fiber properties. The difference in fiber properties between fibers in a row may be arranged in a customized manner such that the output optical characteristics from each or one of the different fiber cores may be optimized and/or complemental to those from other fibers.

In an embodiment, HC-PCFs in each column may have substantially the same fiber properties which may be different to those of the fibers in a different column, so as to provide radiation with a different radiation characteristic. As such, the output radiation generated from a fiber in a specific column may be optimized in a specific spectral range. For example, the output radiation ORD from the fibers in the first column, e.g., the left-most column of the fiber assembly FAA in Figure 12, may be optimized in the spectral range between 200nm and 800nm, the fibers in the second column, i.e. the column next to the first column, may be optimized in the spectral range between 600nm and 1200nm, the fibers in the third column may be optimized in the spectral range between 1000nm and 1600nm, the fibers in the fourth column may be optimized in the spectral range between 1400nm to 2000nm, the fibers in the fifth column may be optimized in the spectral range between 1900nm and 2500nm. Note that, the same spectral coverage, e.g., 200nm to 2500nm, may be equally achievable using any other number of optical fibers, which may be for example, 2, 3, 4, or 6.

In such a customized fiber arrangement, a broad spectral coverage, e.g., 200nm to 2500nm, can be obtained by sequentially switching between fibers in different columns and the overall fiber lifetime can be extended by sequentially switching between fibers in different rows. In this case, fiber core switching may be initiated by a command sent either by a metrology tool or an operator and enabled by a control system of the broadband radiation source RDS1 which controls for example the movement of the fiber assembly FAA. This arrangement may be preferred for applications where multiple different spectral bands are desired but not simultaneously required. Since this customized arrangement may allow each fiber to be optimized for a particular spectral range/band, the output radiation from each fiber may be non-overlapping with the fiber resonance bands that are determined by the fiber structure, e.g., core-wall thickness and/or core diameter. Less or no light-glass (e.g., cladding structure) overlapping means less heating inside the cladding structure and thus longer lifetime of the fiber.

In cases where a broad spectral coverage, e.g., 200nm to 2500nm, is desired to be provided simultaneously rather than sequentially from the fiber assembly FAA, the input radiation IRD may be spatially split into multiple separate beams, each of which is subsequently focused into a different fiber within a row. The multiple beams of output radiation ORD with multiple different spectral bands may then be spatially and temporally recombined into a single broadband output beam. Figure 13 schematically illustrates a multi-beam configuration of the broadband radiation source comprising a fiber assembly FAA in accordance with an embodiment. The fiber assembly FAA may be simultaneously pumped by multiple beams of input radiation IRD. The fiber assembly FAA may be for example any one of the above described fiber assemblies FAA1-FAA4.

Where the fiber assembly comprises a 2D fiber assembly (e.g., assembly FAA1 of Figure 10(a)) in a radiation source such as source RDS2 of Figure 13, a 1D array of multiple (e.g., five) input beams IB1-IB5 may be generated by passing the input radiation IRD through a beam splitting arrangement BSA. The beam splitting arrangement BSA may comprise for example an array of individual beam splitters, e.g., parallel glass plates. Each of the beam splitters may have suitable optical coatings optimized for a desired splitting ratio for the spectral band of the input radiation IRD. The five input beams IB 1-IB5 may have substantially the same optical characteristics and may be respectively focused into the five hollow cores HC of a certain row (e.g., OF1-OF5 in the top row) of the fiber assembly FAA1 by means of a first focusing arrangement FS1. The first focusing arrangement FS1 may be placed in-between the beam splitting arrangement BSA and the first transparent window TW1. At the output end, a second focusing arrangement FS2 may be used to collimate the five beams of output radiation ORD and a beam combining arrangement BCA may be used to spatially recombine the five beams of output radiation ORD into a single output beam. The beam combining arrangement BCA may comprise for example five reflective mirrors arranged to direct each of the beams of output radiation ORD to the same output beam path. Each of the reflective mirrors may have a highly reflective coating optimized for the spectral band of an output beam being directed by the mirror. Additionally or optionally, an optical delay arrangement may be placed in-between the second focusing arrangement FS2 and the beam combining arrangement BCA to compensate or customize the optical delay between different beams of output radiation.

In some embodiments, the focusing arrangements FS1, FS2 may comprise a 1D or 2D array of individual optical lenses. In different embodiments, the focusing arrangements FS1, FS2 may comprise a 1D or 2D micro-lens array comprising an array of micro-lenses fabricated in a single optical substrate. In other different embodiments, the focusing arrangements FS1, FS2 may comprise a spatial light modulator, such as digital micro-mirror device (DMD) comprising a 1D or 2D array of individually controllable micro-mirrors. Each of the micro-mirrors may comprise a suitable radius of curvature configured to focus one of the input beams into one of the hollow cores. Using spatial light modulators e.g., DMD, as focusing arrangements FS1, FS2, the radiation source RDS2 of Figure 13 may not only allow for sequential pumping of multiple hollow cores HC of the fiber assembly FAA with a single beam of input radiation IRD, but also allow for simultaneous pumping of multiple hollow cores HC of the fiber assembly FAA with an array of multiple input beams. When the radiation source RDS2 is used in any of the aforementioned metrology tools, multiple illumination beams with different spectral bands and numerical apertures could be achieved in order to provide simultaneous illumination in different parts of a sample and/or in different spectral bands.

As described above, fiber core switching may be achievable by translating the fiber assembly FAA with respect to the beam of input radiation IRD, and/or shifting the beam of input radiation IRD with respect to the fiber assembly FAA. Figure 14 schematically illustrates a broadband radiation source RDS3 arrangement comprising a fiber assembly FAA in accordance with an embodiment and a second single input beam configuration. Different to the first configuration shown in Figure 12, in the second configuration, the beam of input radiation IRD may be shifted with respect to the fiber assembly FAA. Spatial shifting of the input beam may be achievable by means of a first optical beam shifter OBS1. In some embodiments, the first optical beam shifter OBS1 may comprise for example at least one plane-plane parallel glass plate. A plane-plane parallel glass plate may have an optical input surface and an optical output surface, which are both substantially flat and are substantially parallel to each other. Plane-plane parallel glass plates may only displace an optical beam without causing pointing changes to the beam of input radiation IRD. The amount of beam displacement may be dependent on an input angle formed between the input beam and the optical input surface. When a plane-plane parallel glass plate is arranged such that the optical input surface (and optical output surface) is perpendicular to the input optical beam of input radiation IRD, i.e. the input angle being 90°, it may cause no or negligible beam displacement to the input beam. Whereas, when the input angle moves away from 90° as a result of the glass plate being rotated with respect to the input beam, e.g., about the X-axis in Figure 12, spatial displacement of the input beam may be generated, e.g., in the Y-Z plane. The amount of spatial displacement may be proportional to the angle difference between a new angular position and the non-displacement angular position, i.e. the input angle being 90°. The input and out surfaces of a plane-plane parallel glass plate may have coatings that are anti-reflective in the spectral range of the input radiation IRD.

In the case of a 1D fiber assembly, e.g., the fiber assembly FAA3 of Figure 11(a), being used in the radiation source RDS3 of Figure 14, a 1D beam shifting element such as a single parallel glass plate may be used to shift the beam of input radiation IRD vertically or in the plane defined by the Y and Z directions. By varying the rotation angle of the parallel glass plate, the beam path of input radiation IRD may be shifted, for example from a first beam path BP1 to a second beam path BP2 and subsequently to a third beam path BP3. The parallel glass plate may be mounted on a rotary actuator capable of providing high precision rotational movement. The angular positions of the parallel glass plate may be predetermined based on the spatial separation between two neighboring fiber cores of the fiber assembly FAA3 and the magnification of a first optical lens OL1. Whenever a current optical fiber OF is due for replacement, the input radiation IRD may be at least partially blocked by means of e.g., a beam block. The rotary actuator may rotate the parallel glass plate so as to ensure the beam of input radiation IRD propagating along a new beam path is substantially aligned with the hollow core HC of a new optical fiber OF. For example, when the beam path of the input radiation IRD changes from the first beam path BP1 to the second beam path BP2, a new optical fiber OF3 is then used to generate broadband output radiation ORD rather than the previous optical fiber OF1.

Once the beam of input radiation IRD is in the target beam path, the attenuated or full input radiation IRD may be allowed to enter the hollow core HC of the new fiber. Subsequently, the radiation source RDS3 may enter an input coupling optimization mode in which the coupling between the input radiation IRD and the hollow core HC of the new fiber is optimized. The input coupling optimization may be evaluated by monitoring certain optical characteristics of the output radiation, e.g., spectrum and/or power while adjusting one or more components of the radiation source RDS3. In some embodiments, the input coupling optimization may involve for example fine scanning of the position of the input beam with respect to the fiber core in the X, Y and Z directions. Additionally or optionally, the optimization routine may also involve tilting (e.g., tilting about the X direction Rx, tilting about Z direction Rz) of the first optical lens OL1 in order to adjust or optimize the pointing the input beam and/or translating of the first optical lens OL1 (e.g., along the Y direction) in order to adjust or optimize the focus position of the input beam into the fiber core. Similar to the embodiment of Figure 12, the input coupling optimization may be carried out only once when a new fiber assembly FAA is installed. After the initial input coupling optimization, subsequent fiber core switching may be done repeatably without a need for further optimization. However, the input coupling optimization may be re-activated anytime where it is needed (e.g., for fault-finding purposes).

As shown in Figure 14, the radiation source RDS3 may comprise a second optical beam shifter OBS2 which may also comprise at least one plane-plane parallel glass plate mounted on a rotatory actuator. The plane-plane parallel glass plate may have coatings that are anti-reflective in the spectral range of the output radiation ORD. The rotatory actuator of the first optical beam shifter OBS1 and the rotatory actuator of the second optical beam shifter OBS2 may move in combination to a corresponding respective new angular positions which aims to bring the beam of the output radiation back to the default or desired beam path based on which downstream optics (e.g., optics in a metrology tool) may be aligned. The default or desired beam path may be determined by for example optical alignment in a metrology tool in case of the output radiation being used in the tool and/or a position of an output delivery fiber in case of the output radiation being coupled into the output delivery fiber. When the input coupling optimization is complete, the radiation source RDS3 may enter an output coupling mode in which the position of the output beam may be optimized. In some embodiments, the output coupling optimization may comprise for example fine adjustment of the second optical beam shifter OBS2, e.g., by tilting and/or translating the second optical lens OL2.

The plane-plane parallel plate may be comprised of a low dispersion material, for example N-FK58 of CaF2. The advantage of such a material is it can reduce spectral variation of the beam shift d, as the lower dispersion means that refractive index varies less with wavelength. The relation is given by:

$$d = T \cdot \sin\theta \left( 1 - \frac{\cos\theta}{\sqrt{n^2 - (\sin\theta)^2}} \right)$$

where T is the thickness of the plane-plane parallel plate and $\theta$ is the angle of incidence with respect to the plane-plane parallel plate normal. The low dispersion may be advantageous in particular at the output side, due to the wider spectral range

In different embodiments, either or both of the first optical beam shifter OBS1 and the second optical beam shifter OBS2 may comprise one or more galvo-scanners or piezo-mirrors where the sagittal and tangential plane of the reflecting mirror is controlled with submicrometer resolution. By using two or more such mirrors in sequence may allow for a complete alignment of the light beam to the specific hollow-fiber in the fiber assembly.

With continued reference to Figure 14, in the case of a 2D fiber assembly, e.g., fiber assembly FAA1 of Figure 10(a), being used in the radiation source RDS3, the first optical beam shift OBS1 may comprise two plane-plane glass plates, e.g., a first plate and a second plate. The first plate may be rotatable about a first axis and the second plate may be rotatable about a second axis, wherein the first axis and the second axis may be perpendicular to each other and form a plane parallel to an input facet of the fiber assembly FAA. In a preferable embodiment, the input facet of the fiber assembly FAA may be perpendicular to the beam of input radiation IRD. For example, with continued reference to Figure 4, the first glass plate may be arranged to rotate horizontally or about the Z-axis; and the second glass plate may be arranged to rotate vertically or about the X-axis. The first glass plate may be placed either downstream or upstream of the second glass plate. The downstream glass plate may be sufficiently large in the direction along which the input beam is shifted by the upstream glass plate. As such, the downstream glass plate will be able to catch the displaced input beam no matter how large the angle the upstream glass plate is rotated.

In other embodiments, the fiber assembly FAA (e.g., FAA1, FAA2, FAA3 or FAA4) may allow each individual fiber core to be selectively pressurized with different gas medium or vacuum. Selective pressurization of each individual fiber core may be achieved for example by creating one or more gas channels in the support portion of each fiber which connect the fiber core to a different gas supply. Alternatively, such embodiments may comprise the use of HC-PCFs which are not comprised within a gas cell, but have a gas medium enclosed (e.g., sealed) individually within the HC-PCFs Such a configuration may provide additional flexibility in controlling the optical characteristics of the output radiation ORD.

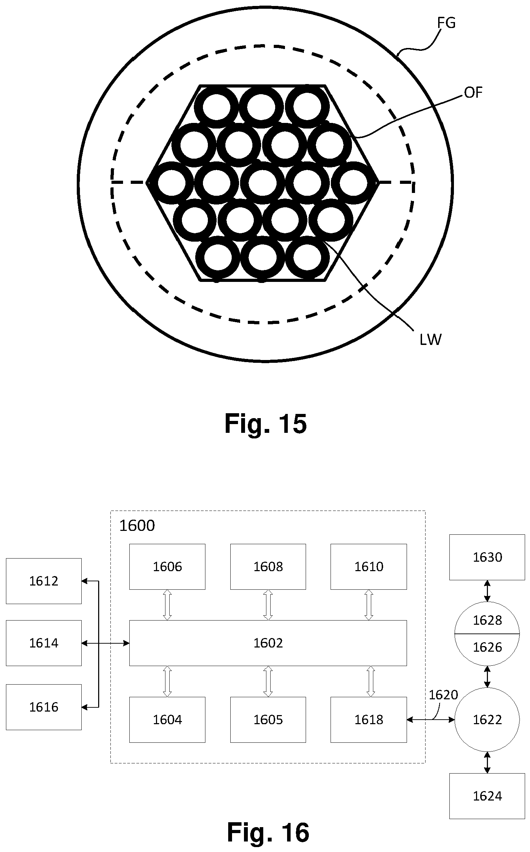

Figure 15 illustrates a multiple fiber stacking embodiment. The Figure shows, in cross section, a number of optical fibers OF within a fiber guide FG. Fiber stacking allows more fibers within a given volume. This has two advantages: longer lifetime of the gas cell through increased redundancy and a smaller pitch which decreases optical beam adjustment range and speed. The Fiber clamping can be achieved by mechanical clamping or alternatively by fusing or (laser) welding LW the tapered fiber ends to each other.

A broadband radiation source configured to extend overall lifetime of the radiation source as disclosed herein, comprises a fiber assembly which may, for example, comprise any of the configurations shown in Figures 10(a), 10(b), 11(a), and 11(b).

A broadband radiation source configured to extend overall lifetime of the radiation source as disclosed herein, comprises a fiber assembly and may comprise any of the configurations shown in Figures 12, 13, 14 or 15.

Figure 16 is a block diagram that illustrates a computer system 1600 that may assist in implementing the methods and flows disclosed herein. Computer system 1600 includes a bus 1602 or other communication mechanism for communicating information, and a processor 1604 (or multiple processors 1604 and 1605) coupled with bus 1602 for processing information. Computer system 1600 also includes a main memory 1606, such as a random access memory (RAM) or other dynamic storage device, coupled to bus 1602 for storing information and instructions to be executed by processor 1604. Main memory 1606 also may be used for storing temporary variables or other intermediate information during execution of instructions to be executed by processor 1604. Computer system 1600 further includes a read only memory (ROM) 1608 or other static storage device coupled to bus 1602 for storing static information and instructions for processor 1604. A storage device 1610, such as a magnetic disk or optical disk, is provided and coupled to bus 1602 for storing information and instructions.

Computer system 1600 may be coupled via bus 1602 to a display 1612, such as a cathode ray tube (CRT) or flat panel or touch panel display for displaying information to a computer user. An input device 1614, including alphanumeric and other keys, is coupled to bus 1602 for communicating information and command selections to processor 1604. Another type of user input device is cursor control 1616, such as a mouse, a trackball, or cursor direction keys for communicating direction information and command selections to processor 1604 and for controlling cursor movement on display 1612. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1600 in response to processor 1604 executing one or more sequences of one or more instructions contained in main memory 1606. Such instructions may be read into main memory 1606 from another computer-readable medium, such as storage device 1610. Execution of the sequences of instructions contained in main memory 1606 causes processor 1604 to perform the process steps described herein. One or more processors in a multi-processing arrangement may also be employed to execute the sequences of instructions contained in main memory 1606. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1604 for execution. Such a medium may take many forms, including but not limited to, non-volatile media, volatile media, and transmission media. Non-volatile media include, for example, optical or magnetic disks, such as storage device 1610. Volatile media include dynamic memory, such as main memory 1606. Transmission media include coaxial cables, copper wire and fiber optics, including the wires that comprise bus 1602. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1604 for execution. For example, the instructions may initially be borne on a magnetic disk of a remote computer. The remote computer can load the instructions into its dynamic memory and send the instructions over a telephone line using a modem. A modem local to computer system 1600 can receive the data on the telephone line and use an infrared transmitter to convert the data to an infrared signal. An infrared detector coupled to bus 1602 can receive the data carried in the infrared signal and place the data on bus 1602. Bus 1602 carries the data to main memory 1606, from which processor 1604 retrieves and executes the instructions. The instructions received by main memory 1606 may optionally be stored on storage device 1610 either before or after execution by processor 1604.

Computer system 1600 also preferably includes a communication interface 1618 coupled to bus 1602. Communication interface 1618 provides a two-way data communication coupling to a network link 1620 that is connected to a local network 1622. For example, communication interface 1618 may be an integrated services digital network (ISDN) card or a modem to provide a data communication connection to a corresponding type of telephone line. As another example, communication interface 1618 may be a local area network (LAN) card to provide a data communication connection to a compatible LAN. Wireless links may also be implemented. In any such implementation, communication interface 1618 sends and receives electrical, electromagnetic or optical signals that carry digital data streams representing various types of information.

Network link 1620 typically provides data communication through one or more networks to other data devices. For example, network link 1620 may provide a connection through local network 1622 to a host computer 1624 or to data equipment operated by an Internet Service Provider (ISP) 1626. ISP 1626 in turn provides data communication services through the worldwide packet data communication network, now commonly referred to as the "Internet" 1628. Local network 1622 and Internet 1628 both use electrical, electromagnetic or optical signals that carry digital data streams. The signals through the various networks and the signals on network link 1620 and through communication interface 1618, which carry the digital data to and from computer system 1600, are exemplary forms of carrier waves transporting the information.

Computer system 1600 may send messages and receive data, including program code, through the network(s), network link 1620, and communication interface 1618. In the Internet example, a server 1630 might transmit a requested code for an application program through Internet 1628, ISP 1626, local network 1622 and communication interface 1618. One such downloaded application may provide for one or more of the techniques described herein, for example. The received code may be executed by processor 1604 as it is received, and/or stored in storage device 1610, or other non-volatile storage for later execution. In this manner, computer system 1600 may obtain application code in the form of a carrier wave.

Further embodiments are disclosed in the follow list of numbered clauses:

1. A broadband radiation source device, comprising:

a fiber assembly comprising a plurality of optical fibers, each optical fiber being filled with a gas medium;
wherein the broadband radiation source device is operable such that subsets of the optical fibers are independently selectable for receiving a beam of input radiation so as to generate a broadband output from only a subset of said plurality of optical fibers at any one time.

2. A broadband radiation source device as defined in clause 1, wherein the broadband radiation source device is operable such that any one of the plurality of optical fibers is singly selectable for receiving a beam of input radiation.

3. A broadband radiation source device as defined in clause 1 or 2, wherein each of said optical fibers comprises a hollow core photonic crystal fiber.

4. A broadband radiation source device as defined in clause 1, 2 or 3, comprising:

a beam splitting arrangement operable to spatially split the beam of input radiation into multiple input beams,
a focusing arrangement to focus each of said multiple input beams into a respective optical fiber of said subset of optical fibers.

5. A broadband radiation source device as defined in clause 1,2 or 3 being operable such that the broadband output is generated from only one of said plurality of optical fibers at any one time.

6. A broadband radiation source device as defined in any preceding clause, wherein the plurality of optical fibers comprise two or more fibers with substantially the same fiber properties.

7. A broadband radiation source device as defined in any preceding clause, wherein the plurality of optical fibers comprise two or more fibers with different fiber properties.

8. A broadband radiation source device as defined in clause 7, wherein some or each of the two or more fibers with different fiber properties is configured to generate the broadband output in a different spectral range.

9. A broadband radiation source device as defined in clause 8, wherein the different spectral range each comprise a different sub-range in a range between 200nm to 2500nm.

10. A broadband radiation source device as defined in any preceding clause, wherein said plurality of optical fibers are stacked together and mechanical clamped, fused or welded together.

11. A broadband radiation source device as defined in any preceding clause, wherein said fiber assembly further comprises a gas cell enclosing the plurality of optical fibers and gas medium.

12. A broadband radiation source device as defined in any preceding clause, wherein the fiber assembly is configured to be movable with respect to the beam of input radiation so as to allow a different one of the plurality of optical fibers to be selected.

13. A broadband radiation source device as defined in any preceding clause, wherein the beam of input radiation is configured to be movable with respect to the fiber assembly so as to allow a different one of the plurality of optical fibers to be selected.

14. A broadband radiation source device as defined in any of clauses 12 or 13, wherein the fiber assembly or the beam of input radiation is movable in one or both directions of a plane perpendicular to a propagation direction of the beam of input radiation.

15. A broadband radiation source device as defined in any preceding clause, configured to switch to a different optical fiber of said plurality of optical fibers to generate said broadband output when a power of the broadband output drops below a threshold level.

16. A broadband radiation source device as defined in any preceding clause, configured to switch to a different optical fiber of said plurality of optical fibers to generate said broadband output when a different optical property of the broadband output is desired; wherein the different optical property comprises a different spectral range.

17. A broadband radiation source device as defined in any preceding clause, further comprising a first beam shifting assembly configured to spatially shift the input radiation with respect to the fiber assembly.

18. A broadband radiation source device as defined in clause 17, wherein the first beam shifting assembly comprises one or more of:

at least one glass plate comprising one or both of a first plate and a second plate, said first plate being rotatable about a first axis and said second plate being rotatable about a second axis, wherein said first axis and said second axis are perpendicular to each other and form a plane parallel to an input facet of the fiber assembly, and optionally wherein said at least one glass plate is comprised of a low dispersion material, for example N-FK58 of CaF2;

at least one piezo-mirror; and

at least one galvo-scanner.

19. A broadband radiation source device as defined in any of clauses 17 or 18, further comprising a second beam shifting assembly configured to spatially shift the broadband output such that the broadband output follows substantially a predetermined beam path.

20. A broadband radiation source device as defined in clause 19, wherein the beam path is determined according to one or both of: optical alignment in a metrology tool configured to use the broadband output, a position of an output delivery fiber configured to deliver the broadband output.

21. A broadband radiation source device as defined in any preceding clause, further comprising a beam block configured to at least partially block the input radiation when switching optical fibers.

22. A broadband radiation source device as defined in any preceding clause, further comprising an input optical lens arrangement configured to couple the input radiation into one of the plurality of optical fibers of the fiber assembly.

23. A broadband radiation source device as defined in clause 22, operable such that position and/or orientation of the input optical lens arrangement is adjustable for optimizing the fiber coupling of the input radiation.

24. A broadband radiation source device as defined in any preceding clause, further comprising an output optical lens arrangement configured to collimate the broadband output.

25. A broadband radiation source device as defined in clause 24, operable such that position and/or orientation of the output optical lens arrangement is adjustable for optimizing position and/or orientation of the broadband output.

26. A broadband radiation source device as defined in any preceding clause, wherein the fiber assembly comprises a multi-core microstructured fiber wherein said optical fibers each comprise a microstructured fiber core.

27. A broadband radiation source device as defined in any preceding clause, wherein the fiber assembly comprises a support portion to support said plurality of optical fibers.

28. A broadband radiation source device as defined in any preceding clause, wherein the plurality of optical fibers is arranged in a 1 dimensional or 2 dimensional linear array.

29. A broadband radiation source device as defined in any of clauses 1 to 27, wherein the plurality of optical fibers is arranged in a ring arrangement comprising a single ring or plurality of concentric rings.

30. A broadband radiation source device as defined in any preceding clause, further comprising a pump radiation source configured to provide the beam of input radiation.

31. A metrology device comprising a broadband light source device as defined in any preceding clause.

32. A metrology device as defined in clause 31, comprising a scatterometer metrology apparatus, a level sensor or an alignment sensor.

33. A method for generating broadband radiation, comprising:

emitting input radiation from a pump source;
receiving the input radiation by a selected subset of a plurality of optical fibers; and
generating from the selected subset of the plurality of optical fibers a broadband output.

34. A method as defined in clause 33, wherein each of said optical fibers comprises a hollow core photonic crystal fiber.

35. A method as defined in any of clauses 33 or 34, wherein the subset comprises a single optical fiber of said plurality of optical fibers.

36. A method as defined in clause 35, comprising switching to another optical fiber of the plurality of optical fibers for the receiving and generating steps.

37. A method as defined in clause 36, wherein said switching step comprises switching to a similar optical fiber when the optical fiber being used for said generating is deemed to require replacement.

38. A method as defined in any of clauses 36 or 37, wherein the optical fiber being used for said generating is deemed to require replacement when a power of the broadband output drops below a threshold level.

39. A method as defined in any of clauses 36 to 38, wherein said switching step comprises switching to a an optical fiber with at least one different fiber property, so as to generate said broadband output to have at least one different radiation characteristic;

40. A method as defined in clause 39, wherein said at least one different radiation characteristic comprises a different spectral range.

41. A method as defined in any of clauses 33 to 40, wherein said switching step comprises one or both of:

moving the fiber assembly with respect to the input radiation; and
moving the input radiation with respect to the fiber assembly.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A broadband radiation source device, comprising:

   a fiber assembly comprising a plurality of optical fibers, each optical fiber being filled with a gas medium;
   wherein the broadband radiation source device is operable such that subsets of the optical fibers are independently selectable for receiving a beam of input radiation so as to generate a broadband output from only a subset of said plurality of optical fibers at any one time.

2. A broadband radiation source device as claimed in claim 1, wherein the broadband radiation source device is operable such that any one of the plurality of optical fibers is singly selectable for receiving a beam of input radiation.

3. A broadband radiation source device as claimed in claim 1 or 2, wherein each of said optical fibers comprises a hollow core photonic crystal fiber.

4. A broadband radiation source device as claimed in claim 1, 2 or 3, comprising:

   a beam splitting arrangement operable to spatially split the beam of input radiation into multiple input beams,
   a focusing arrangement to focus each of said multiple input beams into a respective optical fiber of said subset of optical fibers.

5. A broadband radiation source device as claimed in claim 1,2 or 3 being operable such that the broadband output is generated from only one of said plurality of optical fibers at any one time.

6. A broadband radiation source device as claimed in any preceding claim, wherein the plurality of optical fibers comprise two or more fibers with substantially the same fiber properties.

7. A broadband radiation source device as claimed in any preceding claim, wherein the plurality of optical fibers comprise two or more fibers with different fiber properties and wherein, optionally, some or each of the two or more fibers with different fiber properties is configured to generate the broadband output in a different spectral range.

8. A broadband radiation source device as claimed in any preceding claim, wherein said plurality of optical fibers are stacked together and mechanical clamped, fused or welded together.

9. A broadband radiation source device as claimed in any preceding claim, wherein said fiber assembly further comprises a gas cell enclosing the plurality of optical fibers and gas medium.

10. A broadband radiation source device as claimed in any preceding claim, wherein the fiber assembly is configured to be movable with respect to the beam of input radiation so as to allow a different one of the plurality of optical fibers to be selected.

11. A broadband radiation source device as claimed in any preceding claim, wherein the beam of input radiation is configured to be movable with respect to the fiber assembly so as to allow a different one of the plurality of optical fibers to be selected.

12. A broadband radiation source device as claimed in any preceding claim, further comprising an output optical lens arrangement configured to collimate the broadband output.

13. A broadband radiation source device as claimed in any preceding claim, wherein the plurality of optical fibers is arranged in a 1 dimensional or 2 dimensional linear array or the plurality of optical fibers is arranged in a ring arrangement comprising a single ring or plurality of concentric rings.

14. A metrology device comprising a broadband light source device as claimed in any preceding claim.

15. A method for generating broadband radiation, comprising:

emitting input radiation from a pump source;
receiving the input radiation by a selected subset of a plurality of optical fibers; and
generating from the selected subset of the plurality of optical fibers a broadband output.

**Fig. 1**

**Fig. 2**

**Fig. 3**

**Fig. 4**

**Fig. 5**

**Fig. 6**

OF

CAP        SP

WP        WP

CC   CC

CC   d   CC

CC   CC

HC

y

CAP

x

CAP

WP

**Fig. 7**

RDS

RSV

TW1   IE   WM   OF        OE   TW2

WM

IRD   PRS   ORD

HC

**Fig. 8**

(a)        (b)

ST

**Fig. 9**

Fig. 10(a)

Fig. 10(b)

**Fig. 11(a)**

**Fig. 11(b)**

**Fig. 12**

**Fig. 13**

**Fig. 14**

FG

OF

LW

**Fig. 15**

1600

1612

1614

1616

1606

1608

1610

1602

1604

1605

1618

1630

1628

1626

1620

1622

1624

**Fig. 16**

Europäisches
Patentamt

European
Patent Office

Office européen
des brevets

# EUROPEAN SEARCH REPORT

Application Number

EP 20 20 2720

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 719 551 A1 (ASML NETHERLANDS BV [NL]) 7 October 2020 (2020-10-07) * paragraphs [0116], [0146]; figures 7, 9-11 * | 1-15 | INV. G02F1/35 G02F1/01 G03F7/20 |
| A | US 2019/302570 A1 (KUMAR NITISH [NL] ET AL) 3 October 2019 (2019-10-03) * claim 16; figures 7-9 * | 1-15 | |
| A | US 7 196 839 B1 (SANDERS SCOTT THOMAS [US] ET AL) 27 March 2007 (2007-03-27) * claims 1,10; figure 1 * | 1-15 | |

TECHNICAL FIELDS
SEARCHED      (IPC)

G02F
G03F

The present search report has been drawn up for all claims

| Place of search | Date of completion of the search | Examiner |
|---|---|---|
| The Hague | 5 March 2021 | Gill, Richard |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    .........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 20 20 2720

This annex lists the patent family members relating to the patent documents cited in the above-mentioned European search report.
The members are as contained in the European Patent Office EDP file on
The European Patent Office is in no way liable for these particulars which are merely given for the purpose of information.

05-03-2021

| Patent document cited in search report | | Publication date | Patent family member(s) | | Publication date |
|---|---|---|---|---|---|
| EP 3719551 | A1 | 07-10-2020 | NONE | | |
| US 2019302570 | A1 | 03-10-2019 | CN | 109313404 A | 05-02-2019 |
| | | | EP | 3469425 A1 | 17-04-2019 |
| | | | JP | 2019525217 A | 05-09-2019 |
| | | | KR | 20190016560 A | 18-02-2019 |
| | | | KR | 20210009437 A | 26-01-2021 |
| | | | NL | 2019009 A | 13-12-2017 |
| | | | TW | 201809921 A | 16-03-2018 |
| | | | TW | 201937314 A | 16-09-2019 |
| | | | US | 2019302570 A1 | 03-10-2019 |
| | | | WO | 2017211694 A1 | 14-12-2017 |
| US 7196839 | B1 | 27-03-2007 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20160370717 A
- US 7265364 B
- US 7646471 B
- US 2010233600 A1
- WO 2016102127 A1
- US 6961116 B
- US 2015261097 A1
- US 2004015085 A1
- WO 2017032454A1 A
- WO 2017032454 A1
- WO 2018127266 A1
- US 9160137 B1